(19) Europäisches Patentamt
European Patent Office
Office européen des brevets

(11) Veröffentlichungsnummer: **0 006 428**
**B1**

(12) **EUROPÄISCHE PATENTSCHRIFT**

(45) Veröffentlichungstag der Patentschrift: **16.06.82**

(51) Int. Cl.³: **H 01 L 27/02, H 01 L 29/10**

(21) Anmeldenummer: **79101350.1**

(22) Anmeldetag: **03.05.79**

(54) Halbleiteranordnung für ein Schwellwertelement.

(30) Priorität: **30.06.78 US 920920**

(43) Veröffentlichungstag der Anmeldung:
**09.01.80 Patentblatt 80/1**

(45) Bekanntmachung des Hinweises auf die Patenterteilung:
**16.06.82 Patentblatt 82/24**

(84) Benannte Vertragsstaaten:
**DE FR GB**

(56) Entgegenhaltungen:
FR - A - 2 030 175
US - A - 3 639 813
US - A - 3 648 127
US - A - 3 444 397
US - A - 4 039 869

JOURNAL OF APPLIED PHYSICS, Band 44, Juni 1973, New York, US,
J. F. VERWEY: "Nonavalanche injection of hot carriers into SiO₂", Seiten 2581—2687

(73) Patentinhaber: **International Business Machines Corporation**
**Armonk, N.Y. 10504 (US)**

(72) Erfinder: **Jambotkar, Chakrapani Gajanan**
**154 Hosner Mountain Road**
**Hopewell Junction, NY 12533 (US)**

(74) Vertreter: **Gaugel, Heinz, Dipl.-Ing.**
**Schönaicher Strasse 220**
**D-7030 Böblingen (DE)**

(56) Entgegenhaltungen:
PROCEEDINGS OF THE FIRST CONFERENCE ON SOLID STATE DEVICES, In supplement to the journal of the Japan Society of applied physics", Band 39, 1970, Tokyo, JP
Y. TERUI et al.: "A hybrid type field-effect transistor", Seiten 111—116
SOLID STATE ELECTRONICS, Band 14, September 1971, London GB,
H. S. FU et al.: "A distributed gate bistable MOS transistor", Seiten 799—804

Halbleiteranordnung für ein Schwellwertelement

Die Erfindung befaßt sich mit dem Aufbau einer Halbleiteranordnung für ein Schwellwertelement mit einem Paar elektrischer Anschlüsse, zwischen denen eine nach Überschreitung eines definierten Schwellenspannungswertes im wesentlichen konstante Spannung trotz Einsatz einer Spannungsschwankungen unterworfenen Spannungsquelle auftritt.

Eine Halbleiteranordnung gemäß dem ersten Teil des Anspruchs 1 ist aus US—A—3 444 397 bekannt.

Der Schwellenwert derartiger Halbleiteranordnungen läßt sich zwar nach der Herstellung auf elektrischem Wege beeinflussen, der erreichbare Einstellbereich ist jedoch begrenzt.

Aus US—A—4 039 869 ist die Anordnung eines Feldeffektelementes in einem Halbleiterbereich bekannt, der gegenüber einem diesen Halbleiterbereich tragenden Halbleitersubstrat isoliert ist. Die Einstellung oder Beeinflussung des Schwellenwertes des Feldeffektelementes ist hier nicht angesprochen.

Es sind im Stand der Technik auch zahlreiche andere Halbleiterbauelemente für Schwellert- bzw. Stabilisierungsfunktionen bekanntgeworden, unter denen vor allem die sog. Zenerdioden zu nennen sind. Solche Zenerdioden weisen in ihrer Betriebscharakteristik eine vorbestimmte Schwellenspannung auf. Wird an die Zenerdiode ein Potential angelegt, das diesen Schwellwert überschreitet, erfolgt durch Einsatz eines Stromflusses durch die Zenerdiode eine Begrenzung des über der Zenerdiode erscheinenden Spannungsabfalls auf den Wert dieser Schwellenspannung. Obwohl sich Zenerdioden fabrikatorisch mit zahlreichen Schwellenspannungswerten herstellen lassen, ist der Bereich der letzlich zur Verfügung stehenden wählbaren Schwellenspannungswerte jedoch insgesamt eher klein und erweiterungsbedürftig. Darüber hinaus ist der Aufbau von Zenerdioden nicht ohne weiteres, mit den zur Herstellung integrierter Halbleiterschaltungen üblichen Fabrikationsschritten zu erreichen. Schließlich sind die Stromleitungseigenschaften solcher Zenerdioden begrenzt.

Die Erfindung, wie sie in den Patentansprüchen gekennzeichnet ist, löst die Aufgabe, einen mit den üblichen Herstellungsverfahren für integrierte Schaltungen besser zu vereinbarenden Aufbau eines Schwellwertelementes anzugeben, das insbesondere einen vergrößerten Bereich der wählbaren Schwellenspannungswerte bietet, die sich zudem sowohl während der Herstellung als auch nach (Fortsetzung auf Seite 2 der ursprünglichen Beschreibung) der Herstellung elektrisch beeinflussen lassen sollen. Dabei soll weiterhin das Schwellwertelement eine gute Stromleitfähigkeit aufweisen.

Zusammengefaßt sieht die Erfindung für den Aufbau eines derartigen Schwellwertelementes eine Halbleiteranordnung nach der Art eines an sich bekannten Feldeffektelementes vor. Dabei sind in einem isolierten Halbleiterbereich auf einem Substrat in bekannter Weise beabstandet ein Source- und ein Draingebiet vorgesehen, deren äußere Anschlüsse mit den Anschlüssen der zu stabilisierenden Spannungsquelle verbunden sind. Für die Begrenzerwirkung bzw. Schwellwertbildung wird dabei ausgenützt, daß der unterhalb des Draingebiets zum Substrat hin vorliegende Abstandsbereich zur Festlegung eines jeweiligen Schwellenspannungswertes herangezogen wird und mit der spannungsabhängigen Ausdehnung der mit dem Drain und ggf. mit dem Substrat zusammenhängenden Verarmungszone steuerbar abschnürbar ist. Im Falle der Abschnürung des zwischen dem Source- und Draingebiet bestehenden Kanalbereichs von dem außerhalb des Kanalbereichs angelegten (Sperr-) Vorspannungspotential kann im Kanalbereich der die Überspannung begrenzende Querstrom einsetzen. Die mit der Erfindung erzielbaren Vorteile sind in den vielfältigen Ansatzpunkten für die Beeinflußung des jeweiligen Schwellenspannungswertes, in dessen weitem Bereich und dessen mit üblichen Halbleiterschaltungen kompatibler Herstellungsmöglichkeit zu sehen.

Die Erfindung wird im folgenden anhand von Ausführungsbeispielen unter Zuhilfenahme der Zeichnungen näher erläutert.

Es zeigen:

Fig. 1 im einem schematischen Blockschaltbild eine vorteilhafte Einsatzmöglichkeit für ein im Rahmen der Erfindung aufgebautes Schwellwertelement;

Fign. 2A, 2B und 2C verschiedene Querschnittsdarstellungen sowie eine zugehörige Draufsicht auf ein erstes Ausführungsbeispiel der Erfindung;

Fign. 3 bis 6 Querschnittsdarstellungen weiterer Ausführungsbeispiele der Erfindung;

Fig. 7 und 8 Querschnittsdarstellungen zur Erläuterung jeweils eines Aspektes beim Betrieb der Erfindung;

Fig. 9 ein Betriebsdiagramm zur Erläuterung der Erfindung und

Fign. 10A und 10B Querschnittsansichten vons ich im Rahmen der Herstellung ergebenden Zwischenstrukturen.

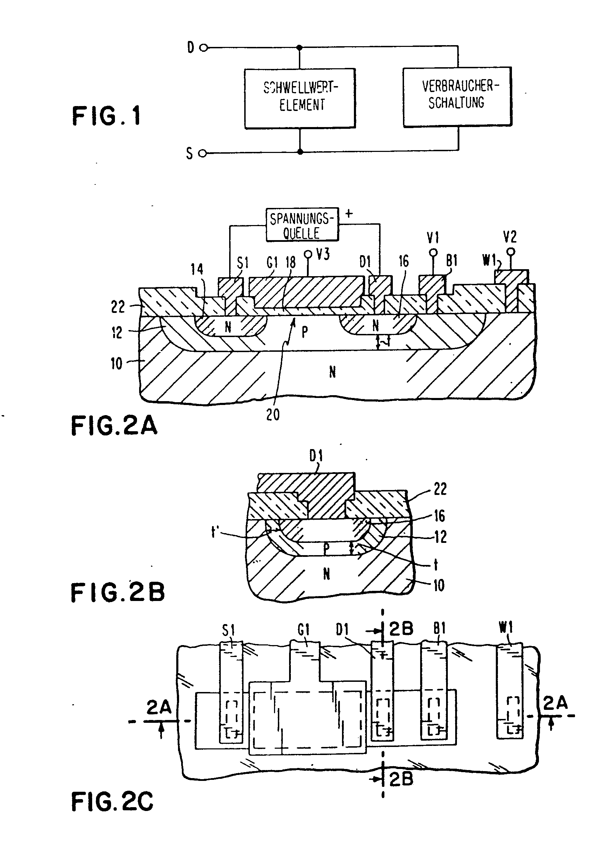

Fig. 1 illustriert in einem schematischen Blockschaltbild die Parallelschaltung eines Schwellwertelementes mit einer Verbraucherschaltung. Von einer Spannungsquelle oder dgl. wird an den mit D und S bezeichneten Anschlüssen eine Potentialdifferenz ausgebildet. Sobald diese Potentialdifferenz den Wert der Schwellenspannung des Schwellwertelementes zu übersteigen beginnt, wird die über den Anschlüssen D und S erscheinende Spannung potentialmäßig festgehalten bzw. -geklemmt. Demnach wird die Verbraucherschaltung bei einer über die Schwellenspannung ansteigen- den Potentialdifferenz der Spannungsquelle lediglich die durch den Wert der Schwellenspannung des Schwellwertelementes vorbestimmte feste Spannung "sehen".

Fig. 2A zeigt einen Querschnitt durch eine die Erfindung enthaltende Halbleiterstruktur. Mittels Diffustion oder Ionenimplantation ist in einem N-leitenden Substrat 10 ein P-dotiertes Gebiet 12 ausgebildet. Ebenfalls mittels Diffusion oder Ionenimplantation sind anschließend daran in das P-dotierte Gebiet 12 die mit 14 und 16 bezeichneten N-dotierten Gebiete eingebracht. Im Rahmen dieses Ausführungsbeispiels soll nun angenommen werden, daß das mit 14 bezeichnete Gebiet als Source und das mit 16 bezeichnete Gebiet als Drain eines Feldeffektelementes dienen soll. Die Dotierungskonzentration sowie die Tiefe des mit 16 bezeichneten Gebietes lassen sich so ausbilden, daß der mit t bezeichnete Abstand zwischen dem Gebiet 16 und dem Substrat 10 sehr genau eingestellt werden kann. Da es bezüglich des Wertes der Schwellenspannung auf den kürzesten Abstand ankommt, der irgendwo zwischen den mit 10 und 16 bezeichneten Gebieten besteht, ist der in Fig. 2B mit t' bezeichnete Abstand ebenfalls evtl. maßgeblich. Durch die exakte Einstellung der mit t und t' bezeichneten Abstände lassen sich somit in einem weiten Bereich die zugehörigen Werte der Schwellenspannungen akkurat einstellen.

Der Bereich zwischen den Gebieten 14 und 16 ist durch eine dünne Siliciumdioxidschicht 18 bedeckt, die man üblicherweise als Gateoxid bezeichnet. Der Bereich unterhalb des Gateoxids umfaßt Oberflächenbereiche des Gebiets 12 und bildet den zwischen Source 14 und Drain 16 sich erstreckenden Kanalbereich 20. Oberhalb des Kanalbereichs 20 und das Gateoxid überdeckend ist die mit G1 bezeichnete Gate-Elektrode vorgesehen, die in an sich bekannter Weise entweder aus Metall oder einem dotierten polykristallinen Silicium (Polysilicium) bestehen kann. Als weitere (Kontakt-) Elektroden sind vorgesehen: S1 für Source 14, D1 für Drain 16, B1 für den Kontakt zum Gebiet 12 und schließlich W1 für den Kontakt zum Substrat 10.

Weiterhin finden sich Schaltungsmittel zum Anlegen der verschidenen Potentiale an die genannten Elektroden. An den mit V1, V2 und V3 bezeichneten Anschlüssen werden die jeweils gewünschten festen Spannungen an die Elektroden B1, W1 und G1 angelegt. Die Spannungsquelle, deren Ausgangspotential festgelegt werden soll, ist dabei an die mit D1 und S1 bezeichneten Anschlüsse angeschlossen. (Parallel dazu wäre natürlich noch die Verbraucherschaltung anzunehmen). Wie in der Zeichnung angedeutet ist, würde das positivere Potential an den mit D1 bezeichneten Anschluß angelegt.

Fig. 2B zeigt einen weiteren Querschnitt durch die Halbleiteranordnung von Fig. 2A, wobei gleiche Teile gleich bezeichnet sind. Aus dieser Querschnittsdarstellung wird ersichtlich, daß das isolierte Halbleitergebiet 12 völlig von Material des Substrats 10 umgeben ist. Weiterhin werden das N-leitende Draingebiet 16 sowie der Drain-Kontakt D1 deutlich. In der in konventioneller Weise die Oberfläche bedeckenden Isolierschicht 22 aus einem Oxid finden sich die jeweiligen Kontaktlöcher, so daß auf diese Art beispielsweise die mit D1 bezeichnete Elektrode das Draingebiet 16 kontaktieren kann. Weiterhin ist in diesem Zusammenhang bekannt, daß an der Grenzfläche zwischen einem Elektrodenmaterial, z.B. für die mit D1 bezeichnete Elektrode, und einem Halbleiterbereich, z.B. 16, eine relativ hohe Dotierungskonzentration erforderlich ist, um einen ohmschen Kontakt zu erhalten. Andernfalls würde eine Schottky-Diode gebildet werden. Im vorliegenden Fall sei die Dotierungskonzentration der verschidenen N-leitenden Bereiche ausreichend hoch gewählt (mindestens etwa $10^{19}/cm^3$), um solche ohmschen Kontakte zu gewährleisten.

Fig. 2C zeigt eine zugehörige Draufsicht, von der die dort eingezeichneten Querschnitte bereits anhand der Fign. 2A und 2B erläutert wurden.

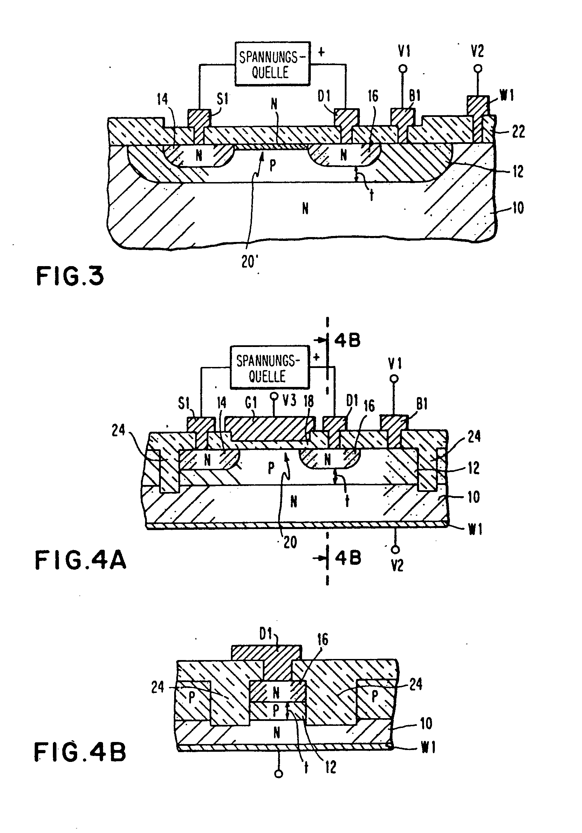

Fig. 3 zeigt in einer Querschnittsdarstellung ein weiteres Ausführungsbeispiel der Erfindung. Soweit diese Darstellung gleiche Teile wie Fig. 2A enthält, finden sich die gleichen Bezeichnungen. Ein bedeutsamer Unterschied zwischen der Anordnung von Fig. 3 und der von Fig. 2A besteht darin, daß Fig. 3 ein Feldeffektelement vom sog. Verarmungstyp zeigt, bei dem eine N-dotierte Schicht zur Bildung des mit 20' bezeichneten Kanalbereichs implantiert ist. Dadurch kann das Erfordernis einer Gate-Elektrode und des Gateoxids beseitigt werden. Das Gateoxid wird dabei ersetzt durch das auch die übrige Oberfläche bedeckende Oxid 22. Da keine Gate-Elektrode gebraucht oder vorgesehen ist, kann auch in diesem Ausführungsbeispiel ein Spannungsanschluß für V3 entfallen.

Fig. 4A zeigt in einer Querschnittsdarstellung ein weiteres Ausführungsbeispiel der Erfindung. Obwohl dabei zum Zwecke der Illustration entsprechend dem Ausführungsbeispiel von Fig. 2A eine Gate-Elektrode G1 und ein mit 18 bezeichnetes Gateoxid vorgesehen ist, kann jedoch auch bei diesem Ausführungsbeispiel die anhand von Fig. 3 erläuterte Version mit einem implantierten Kanalbereich Anwendung finden. Gegenüber den früher beschriebenen Ausführungsformen ist als bedeutsamer Unterschied bei der Anordnung von Fig. 4A anzusehen, daß die Isolation in diesem Fall durch in den Halbleiterkörper eingelassene Oxid-Isolationsbereiche 24 vorgenommen ist, die das mit 12 bezeichnete Halbleitergebiet umgeben. Eine solche Form der seitlichen Isolation mittels versenkter Oxidbereiche ist an sich hinreichend bekannt. Sie wird gebildet, indem man Gräben in den Halbleiterkörper, hier in das mit 12 bezeichnete Gebiet, ätzt und zur Bildung der mit 24 bezeichneten Isolierbereiche an Ort und Stelle oxidiert. Die Isolationsbereiche 24 sollten dabei den zwischen dem Gebiet 12 und dem Substrat gebildeten PN-Übergang durchtrennen, um so das mit 12 bezeichnete Gebiet von anderen vergleichbaren Gebieten zu isolieren. Schließlich ist aus Fig. 4A noch ersichtlich, daß ein Anschluß an das Substrat 10 in konventioneller Weise durch die auf der Rückseite des Halbleitersubstrats angeordnete Elektrode W1 vorgesehen werden kann.

Die weitere Querschnittsdarstellung dieses Ausführungsbeispiels anhand Fig. 4B soll im wesentlichen deutlich machen, wie das versenkte Oxid 24 nicht nur das mit 12 bezeichnete Gebiet sondern auch das Draingebiet 16 umgibt. Dadurch wird eine vollständige Isolation von anderen Teilen der P-dotierten Schicht über dem N-leitenden Substrat 10 erreicht. Festzuhalten ist in diesem Zusammenhang weiterhin, daß die seitlich vorgesehenen Oxidisolationsbereiche 24 zusammenhängend mit den Oberflächenoxidschichten ausgebildet sind, wobei in der Oberflächenoxidschicht die jeweiligen Kontaktlöcher, z.B. für die in Fig. 4B näher herausgestellte Elektrode D1, bestehen.

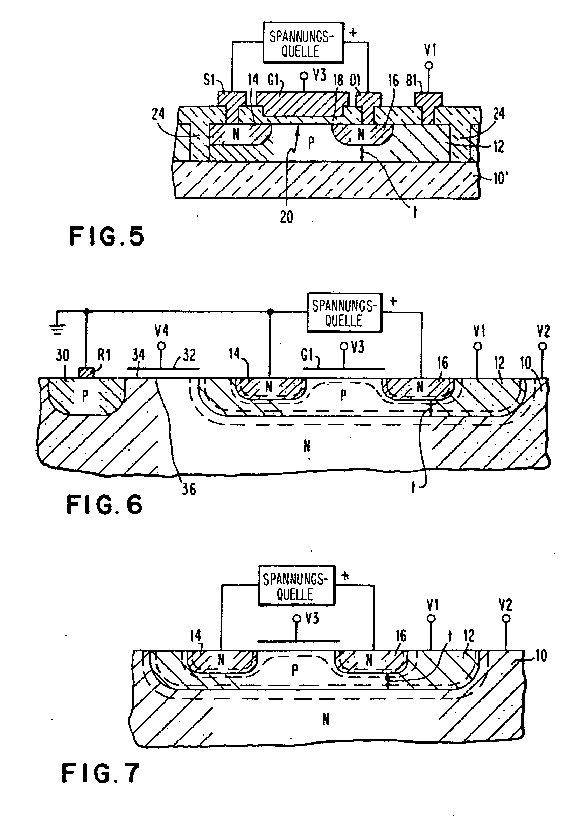

Fig. 5 zeigt ein weiteres Ausführungsbeispiel der Erfindung, das mit vollständig dielektrischer Isolation aufgebaut ist und zweckmäßig als Modifikation des Ausführungsbeispiels von Fig. 4A angesehen werden kann. Wie dort kann auch hier eine Ausführung mit einem implantierten Kanalbereich anstelle eine Gate-Elektrode vorgesehen werden. Der hauptsächlichste Unterschied der Anordnung von Fig. 5 besteht in der Verwendung eines dielektrischen Substrats 10'. Ein solches dielektrisches Substrat 10' kann bekanntermaßen aus einem Material, wie z.B. Saphir bestehen. Materialien dieser Art lassen das einkristalline, epitaxiale Aufwachsen von Silicium zur Bildung von Halbleiterbereichen der mit 12 bezeichneten Art zu. Im übrigen ist die in Fig. 5 gezeigte Halbleiteranordnung identisch mit Fig. 4A, wobei lediglich die mit 24 bezeichneten Isolierschichtbereiche statt in das Substrat hinein lediglich bis zum Substrat 10' hin reichen. Bezüglich anderer Verfahren zur Ausbildung von Halbleiteranordnungen mit vollständiger dielektrischer Isolation sei beispielsweise auf die US-Patentschrift 3 944 447 hingewiesen.

Das weiterhin in Fig. 6 gezeigte Ausführungsbeispiel stellt wiederum eine Modifikation der Anordnung von Fig. 2A dar. Gezeigt ist hier ein Schwellwertelement, das durch Hinzufügung eines FET-Widerstands eine schnellere Ansprechzeit aufweist. Der FET-Widerstand ist dabei durch ein zusätzlich vorgesehenes dotiertes Gebiet 30 mit einer zusätzlichen Gate-Elektrode über dem entsprechenden Gateoxid 34 gebildet. Dadurch wird ein zusätzlicher Kanalbereich 36 und somit eine FET-Wirkung zwischen den P-Gebieten 30 und 12 erzielt. Über die mit R1 bezeichnete Elektrode erfolgt der Kontakt zum Dotierungsgebiet 30. Diese Elektrode R1 kann entweder an ein zusätzliches festes Potential oder an dasselbe Referenzpotential wie das Source-Gebiet 14 angeschlossen werden. Die Gate-Elektrode 32 liegt auf einem festen Potential V4, das demgegenüber relativ negativ gehalten wird, wodurch der P-Kanal FET-Widerstand stets im Einschaltzustand vorgespannt wird. Dadurch ist zwischen den P-Gebieten 12 und 30 ein relativ hoher Widerstandswert von ungefähr 100 k$\Omega$ wirksam.

Unter Bezugnahme auf die Fign. 6 bis 9 soll nun auf die Arbeitsweise des Schwellwertelementes nach der Erfindung eingegangen werden. Eine wichtige, mit der Erfindung erzielbare Eigenschaft besteht darin, daß man den Wert der Schwellenspannung innerhalb eines sehr großen Bereichs von wenigen Volt bis hin zu Hunderten von Volt auf jeweils einen bestimmten gewünschten Wert einstellen kann. Der Schwellenwert wird bestimmt durch die diversen Dotierungskonzentrationen und die oben bereits erwähnte Dimensionierungsgröße t (bzw. t'). Darunter ist, wie bereits erwähnt, der Abstand zwischen dem Drain-Dotierungsgebiet und dem Substrat zu verstehen, was letztlich der Abmessung des sog.

Pinch-off- bzw. Abschnürungsbereichs gleichkommt. Der Schwellenwert wird darüber hinaus beeinflußt von der jeweiligen Dicke des Gateoxids (in Fällen mit einer solchen Gate-Ausführung) bzw. dem Dotierungsgrad für die Kanalimplantation (in Fällen, bei denen keine derartige Gate-Ausführung benutzt wird). Schließlich können auch die verschiedenen an das Schwellwertelement anzulegenden Spannungswerte noch nach Fertigstellung des Bauelements die jeweilige Schwellenspannung beeinflussen und damit steuerbar ausführen. An hand von Fig. 7 soll zunächst auf einige Betriebsbedingungen eingegangen werden, durch die das Schwellwertelement im ausgeschalteten Zustand gehalten wird. Auch dabei wird wieder von den insoweit gleichen Bezeichnungen aus den früheren Darstellungen Bezug genommen. Um die Beschreibung der Operationsweise möglichst zu vereinfachen, sind in der insoweit schematischen Darstellung von Fig.7 die in Wirklichkeit vorhandenen Oxidschichten und Elektroden nicht näher im Detail dargestellt. Von der Spannungsquelle wird an das Draingebiet 16 eine relativ zum Sourcegebiet 14 positive Spannung angelegt, wobei es diese positive Spannung ist, die bei Überschreitung der Schwellenspannung durch das betreffende Schwellwertelement beeinflußt werden soll. Das an das Sourcegebiet 14 angelegte Potential für die Referenzspannung sei Massepotential. Zum Zwecke der Erläuterung der Arbeitsweise sei ferner angenommen, daß dasselbe Potential (Masse) über den Anschluß V2 am Substrat anliegt. Weiterhin sei ein typischer Potentialwert von 1 bis 2 Volt am Anschluß V3 vorhanden, der mindestens so groß ist, daß die Gate-Elektrode Minoritätsträger in den Kanalbereich anziehen und somit den Drain-Source-Leitungspfad in den Einschaltzustand bringen kann. Weiterhin sei über den mit V1 bezeichneten Anschluß eine negative Vorspannung in der Größenordnung von −3 V and das mit 12 bezeichnete Gebiet angelegt. Ausgegangen werden soll nun zunächst davon, daß die Spannungsquelle an ihrem positiven Anschluß eine Spannung von 0 Volt an das Draingebiet 16 abgibt. Da V1 die negativste Spannung ist und am P-Gebiet 12 anliegt, sind alle PN-Übergänge in Sperrichtung vorgespannt, so daß sich die in der Fig. 7 angedeuteten Grenzen der Raumladungszonen bzw. Verarmungsgebiete einstellen.

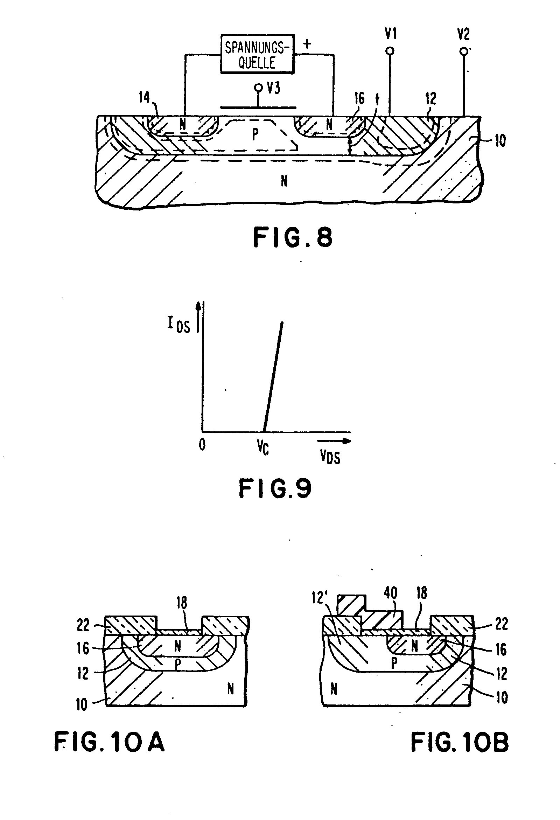

Solange nun die von der Spannungsquelle gelieferte positive Spannung an das Draingebiet 16 einen relativ geringen Wert aufweist, werden sich die Grenzen der Verarmungsgebiete, gebildet durch die gesperrten PN-Übergänge zwischen den Gebieten 12 und 16 sowie 12 und 10, aufgrund des voreingestellten Abstandes t bzw. t' nicht treffen. Das Potential V3, obwohl an sich hoch genug, um eine Oberflächeninversion im Kanalbereich hervorzurufen, bewirkt im Falle des in Fig. 7 dargestellten Beispiels wegen der Dicke der Gate-Isolierschicht, dem Dotierungsgrad des Gebiets 12 und der negativen Vorspannung V1 diesen Effekt nicht. Durch eine Erhöhung der Spannung am Anschluß V2, z.B. auf +10V, kann die Raumladungszone entlang dem PN-Übergang zwischen den Gebieten 10 und 12 dicker gemacht werden, in dem in Fig. 7 illustrierten Fall wird dadurch aber noch nicht der mit t bezeichnete Abstandsbereich überwunden. In gleicher Weise wird mit einem Potentialanstieg am positiven Anschluß der Spannungsquelle das Draingebiet 16 positiver, so daß die Verarmungszone am PN-Übergang zwischen den Gebieten 16 und 12 dicker wird. Das Potential am Draingebiet 16 kann zunehmen, und solange von der zugehörigen Verarmungszone der mit t bezeichnete Abstandsbereich nicht voll erfaßt wird, verhindert die negative Vorspannung des Gebiets 12 eine Inversion im Kanalbereich und damit einen Stromfluß zwischen Drain 16 und Source 14. Diese in Fig. 7 angedeutete Situation wird solange vorherrschen, wie die an das Draingebiet 16 angelegte Spannung relativ zur Spannung am Source-Gebiet 14 kleiner als die Schwellenspannung VC des durch diese Anordnung gebildeten Schwellwertelementes ist. In Fig. 9 ist die zugehörige Charakteristik dargestellt, die für diese Situation zeigt, daß bei einer Drain-Source-Spannung (VDS) kleiner als VC kein Drain-Source-Strom (IDS) fließt.

Fig. 8 veranschaulicht nun den Fall, daß das von der Spannungsquelle gelieferte Potential soweit angestiegen ist, daß sich die mit den jeweiligen PN-Übergängen zwischen den Gebieten 16 und 12 sowie 10 und 12 verbundenen Grenzen der Raumladungszonen treffen und somit den mit t bezeichneten Abstandsbereich voll erfassen. Die dermaßen erhöhte Spannung am Draingebiet 16 bewirkt effektiv eine Abschnürung des P-Gebiets zwischen dem Draingebiet 16 und dem Substrat 10. Aus diesem Grunde ist die am Anschluß V1 anliegende negative Vorspannung nicht mehr länger auch an dem Teil des P-Gebiets 12 angelegt, der sich direkt unterhalb des Kanalbereichs 20 befindet. Damit kann dieser Teil des P-Bereichs 12 potentialmäßig auf etwa Massepotential ansteigen. Wenn sowohl am Anschluß V2 als auch am Sourcegebiet 14 Massepotential anliegt, nimmt auch der Bereich des P-Gebiets 12 direkt unterhalb des Kanalbereichs 20 Massepotential an. Erhält auf der anderen Seite das Substrat 10 am Anschluß V2 ein negatives Potential relativ zum Massepotential am Sourcegebiet 14, nimmt der Bereich des P-Gebiets 12 direkt unterhalb dem Kanalbereich 20 ein Potential an, das in der Nachbarschaft von etwa 0,1 bis 0,4 V liegt und einer leichten Durchlaß-Vorspannung des PN-Übergangs zwischen dem Sourcegebiet 10 und dem benachbarten Teil des P-Gebiets 12 entspricht. Wenn das Potential in dem unter dem Kanalbereich 20 liegendent Teil des P-Gebiets 12 ansteigt, bewirkt die am Anschluß V3 anliegende Gate-Vorspannung nunmehr erfolgreich eine Inversion im Kanalbereich, so daß ein Drain-Source-Strom (IDS) zwischen dem Draingebiet 16 und dem Sourcegebiet 14 fließen kann. Der Wert der Schwellenspannung VC, an dem ein solcher Drain-Source-Stromfluß IDS beginnt, ist in Fig. 9 dargestellt. Mit weiter zunehmenden Potential der Spannungsquelle nimmt auch der Stromfluß im Kanalbereich zu. Würde demnach die Spannungsquelle sehr viel positivere Spannungswerte liefern, würde der Stromfluß vom Draingebiet 16 zum Sourcegebiet 14 beträchtlich zunehmen und damit die letztlich maßgebliche Potentialdifferenz im wesentlichen auf dem Wert der Schwellenspannung VC halten. Da am Anschluß V3 eine konstante Vorspannung aufrechterhalten wird, bleibt auch die Gate-Substratvorspannung konstant. Der Drain- und Source-Anschluß des Schwellwertelements ist jeweils mit einem zugehörigen Anschluß einer (nicht dargestellten) Verbraucherschaltung verbunden. Auf diese Weise erhält die Verbraucherschaltung eine im wesentlichen fest auf das Potential VC begrenzte Versorgungsspannung. Mit abnehmendem Pluspotential der Spannungsquelle nimmt auch der erwähnte Stromfluß ab, bis das Draingebiet 16 potentialmäßig unter VC zu liegen kommt. Ab dann berühren sich die mit den Gebieten 16 und 12 sowie 12 und 10 verbundenen Grenzen der Raumladungszonen nicht mehr. Die Abschnürung des mit t bezeichneten Abstandsbereichs entfällt und die negative Vorspannung
vom Anschluß V1 wird wieder an das P-Gebiet
unterhalb des Kanalbereichs angelegt, wodurch
der Stromfluß vom Draingebiet 16 zum Sourcegebiet 14 unterbrochen wird.

Da der Anschluß V3 auf einem konstanten
Potentialwert gehalten wird, um eine Inversion
des Kanalbereichs durch Anziehung von
Minoritätsträgern veranlassen zu können, wird
aber auch deutlich, daß dasselbe Ergebnis durch
Implantation von Minoritätsträgern in den
Kanalbereich erreicht werden kann, wodurch
das Erfordernis einer festen Gate-Vorspannung
entfallen kann. Demzufolge wird in den oben beschriebenen Ausführungsbeispielen, bei denen
ein ionenimplantiertes Gebiet das fest vorgespannte Gate ersetzt, das zugehörige Bauelement in gleicher Weise durch eine negative
und dem Gebiet 12 zugeführt Vorspannung im
ausgeschalteten Zustand gehalten. Die Vorsehung solcher ionenimplantierter Kanalgebiete
liefert Feldeffekttransistoren vom sog.
Verarmungstyp, die normalerweise eingeschaltet sind, es sei denn, daß eine ausreichend hohe negative Vorspannung am Anschluß V1 vorgesehen ist. Wird demzufolge
diese negative Vorspannung vom Kanalbereich
abgetrennt, indem die oben beschriebene Abschnürung auftritt, kann der Drain-Source-
Leitungspfad Strom führen. Damit arbeitet auch
eine derart aufgebaute Halbleiteranordnung mit
einem ionenimplantierten Kanalbereich in
gleicher Weise wie zuvor mit einer festen Gate-
Vorspannung beschrieben. Wenn demnach in
der zuvor erwähnten Weise hinsichtlich des mit
t bezeichneten Abstandsbereichs der Abschnüreffekt eintritt, kann sich der Teil des P-Bereichs
12, der nun von der negativen Vorspannung am
Anschluß V1 isoliert (abgeschnürt) ist, auf ein
Potential in der Nähe des Massepotentials aufladen. Die Umschaltzeit vom Aus-Zustand in
den Ein-Zustand wird in Abhängigkeit von den
sich dynamisch ändernden Kapazitäts- und
Widerstandwerten etwa in der Größenordnung
von 3 bis 4 ms betragen. Obwohl das für die
meisten industriellen Anwendungen ausreichend sein dürfte, läßt sich diese Übergangszeit erforderlichenfalls noch verkürzen. Eine
Möglichkeit zur Verschnellerung der Übergangszeit besteht in einem selektiven Ionenbeschuß der von dem Source-Gebiet 14 und
dem umgebenden P-Material gebildeten Diode.
Dadurch läßt sich die Übergangszeit vom Auszum Ein-Zustand auf etwa 4 bis 40 $\mu$s verringern. Selbst eine weitere Verschnellerung ist
noch möglich, wenn man eine zusätzliche
Widerstandsstruktur vorsieht.

Eine solche Widerstandstruktur befindet sich
bereits in der oben behandelten Fig. 6 und besteht letztlich aus einer P-Kanal Feldeffekttransistorstruktur, die zwischen dem mit 12
bezeichneten Dotierungsgebiet und einem
Zusätzlichen mit 30 bezeichneten P-leitendem Gebiet ausgebildet ist, und für die ein Gate 32 mit einer festen negativen Vorspannung vorgesehen ist, durch die dieser P-Kanal Feldeffekttransistor stets im Ein-Zustand vorgespannt ist. Das zusätzliche P-leitende Gebiet
30 kann an dasselbe Potential wie das Sourcegebiet des Schwellwertelementes angeschlossen sein, was im hier beschriebenen Ausführungsbeispiel Massepotential war. Wenn das
Schwellwertelement sich im Aus-Zustand befindet, reicht der Strom durch den relativ hohen
Widerstand (ungefähr 100 k$\Omega$) nicht aus, die
Wirkungsweise des Schwellwertelementes zu
bewirken. Wird jedoch die oben behandelte
Schwellenspannung hinsichtlich der Drain 16
überschritten und tritt demzufolge die
Abschnürwirkung ein, kann der Strom vom
Gebiet 30 zum abgetrennten Bereich des P-
Gebiets 12 relativ schnell eine Inversion im
Kanalbereich zwischen Sourcegebiet 14 und
Draingebiet 16 zulassen. Dadurch werden Übergangszeiten vom Aus- zum Ein-Zustand in der
Größenordnung von etwa 5 ns erreichbar.

Im Rahmen einer integrierten Halbleiterschaltung wäre davon auszugehen, daß jeweils
ein solches Schwellwertelement für jede zu
stabilisierende Spannung auf dem jeweiligen
Halbleiterplättchen vorgesehen wäre. Da
erfahrungsgemäß lediglich etwa zwei oder drei
solcher Schwellwertelemente auf einem integrierten Halbleiterplättchen erforderlich wären,
würde die zusätzliche Vorsehung einer solchen
Widerstandsstruktur zur Verschnellerung praktisch nicht ins Gewicht fallen. Die Stabilisierung bzw. Begrenzung negativer (statt
positiver) Spannungen kann natülich gleichermaßen im Rahmen der Erfindung erzielt werden,
indem man lediglich die Leitungstypen der
Dotierungsgebiete entgegengesetzt wählt und
die entsprechenden Spannungspolaritäten an
den Anschlüssen umkehrt. Ebenso klar ist, daß
im Fall einer vollständig dielektrisch isolierten
Halbleiterstruktur der in Fig. 5 gezeigten Art die
vom Drain-Gebiet 16 ausgehende Verarmungszone sich bis zum dielektrischen Substrat 10'
erstrecken würde.

Das hier beschriebene Schwellwertelement
hat einen breiten Anwendungsbereich und kann
mittels zahlreicher Halbleiterherstellungsverfahren aufgebaut werden. Im Falle der in Fig. 2A
gezeigten Ausführungsform kann beispielsweise das Substrat 10 aus einem üblichen N-
leitenden Siliciummaterial bestehen. Auf seiner
Oberfläche läßt man eine Schicht aus thermischen Siliciumdioxid mit einer Schichtdicke in
der Größenordnung von etwa 800 nm aufwachsen. Mittels bekannter Photolithographie-
und Ätzverfahren wird in der Siliciumdioxidschicht eine Öffnung zur Ausbildung des P-
dotierten Bereichs 12 hergestellt. Die Dotierung
des Bereichs 12 kann entweder mittels Diffusion oder Ionenimplantation und einem
anschließenden Eintreibschritt erfolgen, der
mindestens teilweise in einer (nicht oxidierenden) Inertgas-Atmosphäre vorgenommen
wird. Über das P-Dotierungsgebiet läßt man anschließend eine dünne Schicht aus thermischen Siliciumdioxid mit einer Schichtdicke von größenordnungsmäßig 15 nm aufwachsen. Mittels eines Photolacks und photolithographischer Verfahren läßt sich ein Maskierungsmuster ausbilden, so daß N-Dotierungsstoffe durch die dünne Oxidschicht implantiert werden können. In einem anschließenden Eintreibschritt werden die P- und N-Dotierungsstoffe in ihre endgültige Position gebracht, während man eine ungefähr 600 nm dicke thermische Oxidschicht aufwachsen läßt. Abgeschlossen wird das Verfahren dann in konventioneller Weise durch die Ausbildung der jeweiligen Metallurgie und/oder Polysilicium-Bereiche, um letztlich zu einer in Fig. 2A illustrierten Struktur zu gelangen.

Eine sich im Rahmen des Herstellungsverfahrens ergebende Zwischenstruktur ist in den Fign. 10A und 10B dargestellt, die zueinander orthogonal angelegte Querschnittsdarstellungen zeigen. Mit 40 ist die Photolackbeschichtung in ihrer entsprechenden Position zur teilweisen Maskierung des Gate-oxids 18 bezeichnet, um das zugehörige ionenimplantierte Gebiet 16 ausbilden zu können. Der vergrößerte Bereich 12' des mit 12 bezeichneten Gebiets in Fig. 10B soll anschließend zum Anbringen der Kontaktelektrode B1 (Fig. 2A) dienen.

Für die Herstellung einer Struktur der in Fig. 2A gezeigten Art kann auch der folgende alternative Verfahrensablauf gewählt werden. Bis zum Verfahrensschritt des Aufwachsens der 15 nm dünnen thermischen Oxidschicht sei der Prozeß mit dem vorbeschriebenen Verfahren gleich. An diesem Verfahrenspunkt wird jedoch statt eines Photolackauftrages zur Maskierung beim Ionenimplantationschritt eine Schicht aus Siliciumnitrid aufgebracht. Diese Nitridschicht wird dann mittels bekannter photolithographischer Verfahrensschritte zu einem jeweils gewünschten Muster umgestaltet, so daß statt der in Fig. B mit 40 bezeichneten Photolackschicht eine entsprechende Schicht aus Siliciumnitrid vorliegt. Die bis zu diesem Zeitpunkt, entsprechend den Fign. 10A und 10B, ausgestaltete Zwischenstruktur wird dann einem Eintauchätz- oder Plasmaätzschritt unterzogen, um die freiliegenden Bereiche des Gateoxids 18 zu entfernen. Das N-Dotierungsgebiet 16 kann dann durch Diffusion im P-Gebiet mit anschließendem Eintreiben sowohl der P- Als auch N-Dotierungsstoffe beim gleichzeitigen Aufwachsen einer 600 nm dicken thermischen Oxidschicht gebildet werden.

## Patentansprüche

1. Halbleiteranordnung für ein Schwellwertelement mit einer Bauelementstruktur nach Art eines Feldeffektelements, bei dem in einem mit einem ersten Vorspannungspotential (V1) beaufschlagten Halbleiterbereich (12) eines ersten Leitungstyps ein Sourcegebiet (14) und beabstandet dazu ein Draingebiet (16) vom jeweils entgegengesetzten zweiten Leitungstyp angeordnet ist, bei dem zwischen den Anschlüssen von Drain- und Sourcegebiet eine Spannungsquelle angelegt ist und bei dem zwischen Drain- und Sourcegebiet eine im wesentlichen konstante Spannung auftritt, sobald die von dieser Spannungsquelle gelieferte Potentialdifferenz einen definierten Schwellenspannungswert überschreitet, dadurch gekennzeichnet, daß der Halbleiterbereich (12) auf ein Substrat (10, 10') aufgebracht und gegen dieses isoliert ist, daß das Draingebiet (16) vom Substrat (10, 10') einen Abstand (t, t') im Material des isolierten Halbleiterbereichs (12) aufweist und daß dieser Abstand zur Festlegung eines jeweiligen Schwellenspannungswertes (VC) herangezogen wird.

2. Halbleiteranordnung nach Anspruch 1, dadurch gekennzeichnet, daß das Substrat (10) ein Halbleitermaterial vom zweiten Leitungstyp ist und mit einem zweiten festen Vorspannungspotential (V2) beaufschlagt ist.

3. Halbleiteranordnung nach Anspruch 2, dadurch gekennzeichnet, daß von einer Isolierschicht (18) getrennt über dem Kanalbereich (20) zwischen dem Source- und Draingebiet (14, 16) eine Gate-Elektrode (G1) angeordnet und mit einem dritten festen Vorspannungspotential (V3) beaufschlagt ist (z.B. Fig. 2A).

4. Halbleiteranordnung nach mindestens einem der vorhergehenden Ansprüche, dadurch gekennzeichnet, daß bei einem ersten Leitungstyp mit P-Leitfähigkeit und einem zweiten Leitungstyp mit N-Leitfähigkeit das erste Vorspannungspotential (V1) relativ zum zweiten und dritten Vorspannungspotential (V2, V3) ein negatives Potential ist.

5. Halbleiteranordnung nach einem der Ansprüch 1 bis 4, dadurch gekennzeichnet, daß zur Festlegung eines jeweiligen Schwellenspannungswertes (VC) die anlegbaren festen Vorspannungspotentiale (z.B. V1, V2, V3) mit einbezogen werden.

6. Halbleiteranordnung nach einem der Ansprüch 1 bis 5, dadurch gekennzeichnet, daß der isolierte Halbleiterbereich (12) mindestens seitlich, vorzugsweise jedoch auch zum Substrat (10, 10') hin, von dielektrischem Isolationsmaterial, vorzugsweise einem Oxid des Halbleitermaterials, umgeben ist (z.B. Fign. 4, 5).

7. Halbleiteranordnung nach einem der Ansprüche 1, 2 oder 4 bis 6 gekennzeichnet durch einen zwischen dem Source- und Draingebiet (14, 16) vorgesehenen dotierten Kanalbereich (20' in Fig. 3) vom gleichen Leitungstyp wie das Source- und Draingebiet.

8. Halbleiteranordnung nach einem der Ansprüche 1 bis 5, dadurch gekennzeichnet, daß mit dem Schwellwertelement ein mit dessen erstem isolierten Halbleiterbereich (12 in Fig. 6) zusammenwirkender Widerstand verbunden ist, der einen vom ersten beabstandeten zweiten isolierten Halbleiterbereich (30) vom gleichen Leitungstyp wie der erste Halbleiterbereich (12) umfaßt.

9. Halbleiteranordnung nach Anspruch 8, dadurch gekennzeichnet, daß der Widerstand nach Art eines Feldeffektelementes aufgebaut ist, dessen Widerstandswert zur verschnellert einsetzenden Begrenzerwirkung des Schwellwertelementes durch eine steuerbare Kanalleitfähigkeit reduziert wird.

**Revendications**

1. Dispositif semi-conducteur pour un élément à seuil ayant une structure du genre à effet de champ, dans lequel on dispose, dans une région semi-conductrice (12) d'un premier type de conductivité à laquelle est appliqué un premier potentiel de polarisation (V1), une région de source (14) et, espacée de celle-ci, une région de drain (16) du second type de conductivité, dans lequel on applique entre les connexions des régions de drain et de source, une source de tension, et dans lequel une tension essentiellement constante apparaît entre les régions de drain et de source lorsque la différence de potentiel fournie par cette source de tension dépasse une valeur de seuil prédéterminée, caractérisé en ce que la région semi-conductrice (12) est disposée sur un substrat (10, 10') et isolée de celui-ci, en ce que la région de drain (16) est espacée du substrat (10, 10') d'une distance (t, t') dans le matériau de la région semi-conductrice isolée (12), et en ce que cette distance est utilisée pour déterminer sa valeur de tension de seuil (VC).

2. Dispositif semi-conducteur selon la revendication 1 caractérisé en ce que le substrat (10) est un matériau semi-conducteur du second type de conductivité auquel on applique un second potentiel de polarisation fixe (V2).

3. Dispositif semi-conducteur selon la revendication 2, caractérisé en ce que, séparée d'une couche isolante (18), on dispose sur la région de canal (20) entre les régions de source et de drain (14, 16), une électrode de porte (G1) à laquelle on applique un troisième potentiel de polarisation fixe (V3) (par exemple la figure 2A).

4. Dispositif semi-conducteur selon au moins l'une des revendications précédentes, caractérisé en ce que pour un premier type de conductivité P et un second type de conductivité N, le premier potentiel de polarisation (V1) constitue un potentiel négatif par rapport au second et troisième potentiels de polarisation (V2, V3).

5. Dispositif semi-conducteur selon l'une quelconque des revendications 1 à 4, caractérisé en ce qu'on utilise les potentiels de polarisation fixes applicables (par exemple V1, V2, V3) pour déterminer une valeur de tension de seuil (VC).

6. Dispositif semi-conducteur selon l'une quelconque des revendications 1 à 5, caractérisé en ce que la région semi-conductric isolée (12) est entourée, au moins latéralement, mais de préférence aussi vers le substrat (10, 10'), par un matériau isolant diélectrique, de préférence un oxyde du matériau semi-conducteur (par exemple les figures 4, 5).

7. Dispositif semi-conducteur selon l'une quelconque des revendications 1, 2, ou 4 à 6, caractérisé par une région de canal dopée (20 de la figure 3) du même type de conductivité que les régions de source et de drain, cette région de canal étant prévue entre les régions de source et de drain (14, 16).

8. Dispositif semi-conducteur selon l'une quelconque des revendications 1 à 5, caractérisé en ce qu'à l'élément à seuil, est associée une résistance qui coopère avec la première région semi-conductrice isolée de celui-ci (12 de la figure 6), cette résistance comportant une seconde région semi-conductrice isolée (30), espacée de la première région, et dont le type de conductivité est le même que celui de la première région semi-conductrice (12).

9. Dispositif semi-conducteur selon la revendication 8, caractérisé en ce que la résistance est conçue comme un dispositif à effet de champ dont la valeur est réduite par une conductivité de canal commandée afin d'accélérer l'effet de limitation de l'élément à seuil.

**Claims**

1. Semiconductor arrangement for a threshold device with a component structure in the manner of a field effect device, wherein a semiconductor region (12) of a first conductivity type applied with a first bias potential (V1), a source region (14) and spaced therefrom a drain region (16) of the respective opposite second conductivity type are arranged, wherein between the connections of drain and source regions a voltage source is applied, and wherein between drain and source regions a substantially constant voltage is provided as soon as the potential difference supplied by this voltage source exceeds a defined threshold value, characterized in that the semi-conductor region (12) is applied onto a substrate (10, 10') and isolated therefrom, that the drain region (16) is distanced (t, t') from the substrate (10, 10') in the material of the isolated semi-conductor region (12), and that this distance is referred to for determining a respective threshold voltage value (VC).

2. Semiconductor arrangement as claimed in claim 1, characterized in that the substrate (10) is a semiconductor material of the second conductivity type and applied with a second fixed bias potential (V2).

3. Semiconductor arrangement as claimed in claim 2, characterized in that separated from an isolation layer (18) over the channel region (20) between the source and drain region (14, 16) a gate electrode (G1) is arranged and applied with a third fixed bias potential (V3) (e.g. Fig. 2A).

4. Semiconductor arrangement as claimed in at least one of the preceding claims, characterized in that in a first circuit type of P-conductivity and a second circuit type of N-conductivity, the first bias potential (V1) relative to the second and third bias potential (V2, V3) is a negative potential.

5. Semiconductor arrangement as claimed in any one of claims 1 to 4, characterized in that for fixing a respective threshold voltage value (VC) the applicable fixed bias potentials (e.g. V1, V2, V3) are also related.

6. Semiconductor arrangement as claimed in any one of claims 1 to 5, characterized in that the isolated semiconductor region (12) is surrounded at least laterally, but preferably also towards the substrate (10, 10') by dielectric isolation material, preferably an oxide of the semiconductor material (e.g. Figs. 4, 5).

7. Semiconductor arrangement as claimed in any one of claims 1, 2 or 4—6, characterized by a doped channel region (20; in Fig. 3) of the same conductivity type as source and drain regions, provided between the source and drain regions (14, 16).

8. Semiconductor arrangement as claimed in any one of claims 1—5, characterized in that connected to the threshold device a resistor coacting with its first isolating semiconductor region (12; in Fig. 6) is provided including a second isolated semiconductor region (30) that is spaced from the first semiconductor region (12), and is of the same conductivity.

9. Semiconductor arrangement as claimed in claim 8, characterized in that the resistor is designed in the manner of a field effect device whose resistance relative to an accelerated limiting effect of the threshold device is reduced by a controllable channel conductivity.

FIG.1

SCHWELLWERT-ELEMENT

VERBRAUCHER-SCHALTUNG

SPANNUNGS-QUELLE

FIG.2A

FIG.2B

FIG.2C

**FIG.3**

**FIG.4A**

**FIG.4B**

FIG.5

FIG. 6

FIG. 7

FIG. 8

FIG.9

FIG.10 A

FIG.10B

4